# EUROPEAN PATENT APPLICATION

(11) **EP 4 742 536 A1**
(43) Date of publication of application: **13.05.2026**
(21) Application number: 24212207.5
(22) Date of filing: 11.11.2024
(51) Int. Cl.: H03K 17/082, H03K 17/10, H03K 17/687

(54) **POWER CONTROL APPARATUS**

(71) Applicant: Future Systems Besitz GmbH, 96472 Rödental (DE)
(72) Inventor: Först, Bernhard, 96317 Kronach (DE)
(74) Representative: Bratovic, Nino Maria

(57) **Abstract**

The present invention relates to a power control apparatus for controlling an electrical current between an input terminal and an output terminal. The current in the path between these two terminals can be monitored by an arrangement comprising a nearly linear conductive element positioned in the current path, and an inductive element that receives the magnetic field generated by the conductive element. The arrangement of the conductive element and the inductive element may form a configuration similar to a planar transformer.

## Description

### Technical Field

The invention relates to a power control apparatus. In particular, the present invention relates to an apparatus that controls power supply by evaluating the current supplied by the power control apparatus.

Electrical loads connected to a power supply system often require control of the supplied electrical power, particularly to protect the connected electrical loads. Such loads may need protection from overload and overcurrent. Additionally, electrical loads connected to a power supply system must sometimes be turned on or off. Therefore, the electrical power supplied to these loads needs to be conditioned during both the turn-on and turn-off phases. A connected load may also have different operational modes, each requiring adaptation or conditioning of the supplied electrical power.

Conventional electrical protection devices often use current sensors to measure the current flowing to the connected load, enabling detection of critical situations and automatic triggering of an electronic or electromechanical switch if a critical situation is detected. A current measurement element, such as a Hall sensor, can measure the electrical current and provide corresponding measurement values to an integrated controller, which may switch off relevant components of the protection device if the measured current values exceed a predetermined threshold. Some conventional protection devices use semiconductor switches, such as MOSFETs, to protect connected loads against overcurrents or overloads.

However, these conventional protection devices typically require sensor elements in the current supply path to measure the electrical current flowing to the connected load. These sensor elements can cause additional energy losses and may hinder the miniaturization of the electrical protection device.

In particular, when electrical current is monitored by a lossy electrically conductive component, such as an inductor, it may result in energy losses that must then be dissipated as heat. Accordingly, it is an objective of the present invention to provide a power control apparatus that controls the electrical power supplied to the connected load while mitigating these effects, thereby reducing energy losses.

This objective is achieved by the features of the independent claim. Further advantageous embodiments are subject matter of the dependent claims

### Summary

In an aspect of the present invention, a power control apparatus is provided. The power control apparatus may be configured for controlling electrical power supplied to a connected load. The apparatus comprises an input terminal, an output terminal, a semiconductor switching stage through which a connected load receives a load current, a conduction element, an induction element and an evaluation circuit.

The input terminal can be connected to an electrical power source. The output terminal can be connected to the load. The semiconductor switching stage comprises two power switching modules. Each power switching module can include one or more power switching elements such as a semiconductor switch. The individual switching elements of a power switching module can be arranged in parallel. The two power switching modules can be arranged in series between the input terminal and the output terminal.

In particular, the two power switching modules have opposite orientations. Accordingly, due to this opposite orientation of the two power switching modules, the power switching stage is able to interrupt an electrical voltage independent of the polarity of the applied voltage. The conduction element is arranged in the current path between the input terminal and the output terminal. For example, the conduction element can be arranged between the input terminal and the semiconductor switching stage.

Additionally or alternatively, it may be possible to arrange the conduction element between the semiconductor switching stage and the output terminal. The induction element is adapted to receive a magnetic field generated by the conduction element. The induction element is further configured to provide an output signal, in particular an output signal corresponding to the magnetic field generated by the conduction element. For this purpose, the induction element may be realized by a conductive structure with one or more loops for receiving the magnetic field. The evaluation circuit is adapted to evaluate a current between the input terminal and the output terminal. In particular, the evaluation circuit may be adapted to evaluate the current between the input terminal and the output terminal based on a voltage provided by the induction element. The evaluation circuit may be also adapted to evaluate a voltage drop over the semiconductor switching stage. Thus, a switching status of the semiconductor switching stage may be controlled or influenced based on an evaluation performed by the evaluation circuit.

The present invention is based on the finding that electrical current may be analysed by a voltage drop along an electrically conducting element. In particular, current changes over time may be monitored by means of an electrically component having inductive properties such as a coil or a conductive structure forming one or more windings. However, such electrically conducting elements usually often exhibits resistive properties which may lead to electrical losses.

The present invention therefore takes into account these findings and aims to provide a concept for analysing an electrical current through a power control apparatus with reduced electrical losses.

The present invention utilizes the concept of magnetic coupling between a conduction element and an additional induction element to achieve this, wherein the current flowing through the conduction element also passes through the semiconductor switching stage. Accordingly, the magnetic field which can be received by the induction element also corresponds to the electric current through the semiconductor switching stage, and thus, an output voltage provided by the induction element may also corresponds to the electric current through the semiconductor switching stage. Due to a relative low resistance of the conduction element, the electrical losses in the main current path, i.e. the current path between the input terminal and the output terminal, and in particular through the conduction element, are relatively low. Further, an appropriate and sufficiently high output voltage provided by the induction element can be achieved by adapting the configuration and in particular the number of windings of the induction element. In this way, it is possible to monitor the electric current in the main path between the input terminal and the output terminal, and in particular to evaluate for a gradient of this electric current.

In a possible embodiment, the induction element may be formed as an electrically conductive structure on a printed circuit board. For example, the induction element can be implemented with a conductive path structure with one or more loops. Such a structure may provide properties which are at least similar to the properties of a coil.

In an alternative embodiment, the induction element may be realised as a discrete component with one or more conductive loops. In particular, the induction element may be realised as a discrete coil. For example, the induction element can be implemented with a wire forming a coil structure.

In a possible embodiment, the conduction element may be formed as an electrically conductive structure on the printed circuit board. For example, the conduction element may be a single line with a straight or at least almost straight conductive section. This conductive structure may be, for example, a conductive structure comprising copper or another appropriate conductive material forming the conductive structure on the printed circuit board. Alternatively, it may be also possible to use a discrete conductive element which is suitable to carry the required current.

In a possible embodiment, the induction element can include only a single conductive structure which is arranged alongside the conduction element. In other words, the induction element is arranged only on one side of the conduction element.

In an alternative embodiment, the induction element comprises at least two separate structures. In particular, at least two sections of the induction element can be arranged at opposite sides of the conduction element. In other words, the conduction element can be arranged between two individual structures of the induction element. In this way, the magnetic coupling between the conduction element and the induction element can be improved. Further, it may be also possible to arrange the induction element or at least some parts of the induction element above and/or below the conduction element, or to form a configuration which surrounds the linear section of the conduction element at least in part.

In a possible embodiment, the power control apparatus may further comprise a coupling element. The coupling element may be adapted to magnetically couple the conduction element and the induction element. For example, the coupling element can include magnetically conductive material. For example, the coupling element can include material commonly used in magnetic cores, for instance ferrite or the like. The coupling element may be spatially arranged above and/or below an area comprising the conduction element and/or the induction element. In particular, the coupling element may be electrically isolated from the conduction element and the induction element. For this purpose, further appropriate components such as an isolating vanish or an isolating film may be used.

In a possible embodiment, the conduction element can be arranged between the input terminal and the semiconductor stage. Additionally or alternatively, the conduction element can be arranged between the semiconductor stage and the output terminal. For example, a first unit with a first conduction element and a first induction element can be arranged between the input terminal and the semiconductor stage, and a second unit with a second conduction element and a second induction element can be arranged between the semiconductor stage and the output terminal. In this case, the output of the first induction element and the second induction element may be combined. Accordingly, the evaluation circuit may consider this combined output as a single signal.

In a possible embodiment, the evaluation circuit can include a rectifier circuit. The rectifier circuit may be configured to rectify an output voltage of the second coil. In this way, a subsequent processing of the rectified voltage may be used to evaluate the amount of an amplitude or a gradient irrespective of the polarity of the current flowing through the power control apparatus.

### Brief description of the Drawings

In the following, possible embodiments of the different aspects of the present invention are described in detail with reference to the enclosed figures.
- Fig. 1: shows a schematic diagram illustrating the basic principle of a power control apparatus;
- Fig. 2: shows a schematic diagram of a power control apparatus with coupled coils according to an embodiment;
- Fig. 3: shows a schematic diagram of a top of a power control apparatus with coupled coils according to an embodiment;
- Fig. 4: shows a schematic diagram of a cross-sectional view of power control apparatus with two magnetically coupled coils according to an embodiment;
- Fig. 5: a schematic diagram of a power control apparatus according to a further embodiment;
- Fig. 6: shows a schematic diagram of a cross-sectional view of power control apparatus according to a further embodiment;
- Fig. 7: shows a schematic circuit diagram illustrating the basic principle of a temperature compensated power control apparatus according to an embodiment; and
- Fig. 8: shows a schematic circuit diagram illustrating of a power control apparatus with a temperature compensation network according to an embodiment.

### Detailed Description of Embodiments

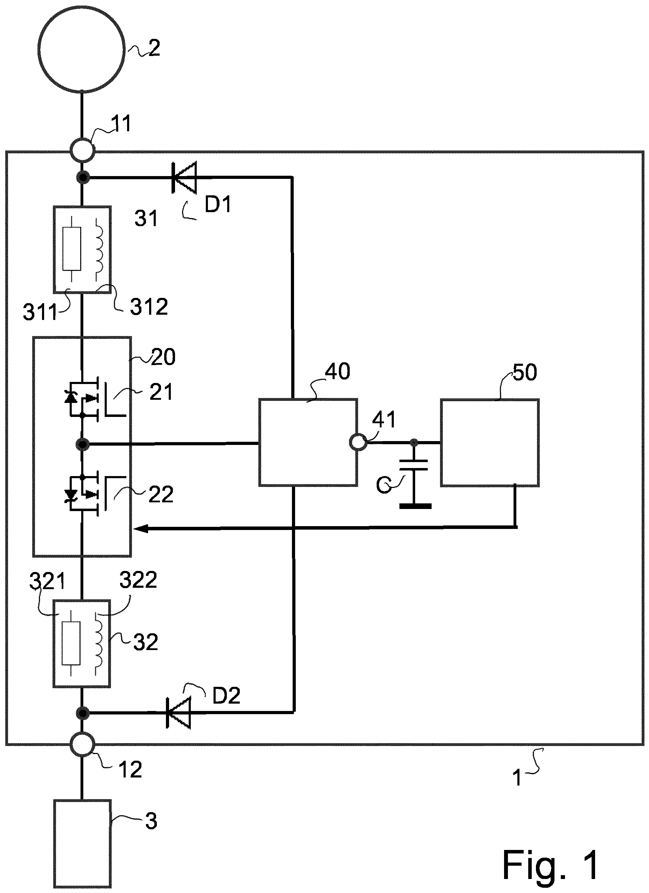

Fig. 1 shows a schematic diagram illustrating the basic principle underlying power control apparatus 1 according to an embodiment. Power control apparatus 1 comprises an input terminal 11 and an output terminal 12. Input terminal 11 may be connected to an electrical power source 2, which could be a DC or AC power source. Output terminal 12 may be connected to an electrical load 3, which operates using power provided by power source 2. For example, electrical load 3 could be an electric machine.

Power control apparatus 1 also includes a semiconductor switching stage 20, arranged in a current path between input terminal 11 and output terminal 12. Semiconductor switching stage 20 comprises two switching modules 21 and 22, each of which includes at least one semiconductor switching element. If switching modules 21 and 22 comprise multiple switching elements, these may be arranged in parallel. The switching elements might be MOSFETs or other suitable semiconductor devices. Importantly, the orientation of the switching elements in module 21 is opposite to that in module 22, allowing semiconductor switching stage 20 to interrupt the voltage between terminals 11 and 12 regardless of polarity.

Additionally, a first electrical component 31 is located between input terminal 11 and semiconductor switching stage 20, while a second electrical component 32 is positioned between semiconductor switching stage 20 and output terminal 12. These components 31 and 32 may include conductive elements 311 and 321, such as components with specific ohmic resistance. Alternatively, they could contain inductive elements 312 and 322, like coils with specific inductance.

To evaluate the magnitude or gradient of the electrical current, it may not be necessary to consider its polarity between input terminal 11 and output terminal 12. Accordingly, evaluation circuit 40 may include a rectifying circuit 42 that rectifies input signals, such as voltage drops across components 31 and 32.

Power control apparatus 1 also comprises an evaluation circuit 40, which assesses the current between input terminal 11 and output terminal 12. For example, evaluation circuit 40 may generate an output signal based on the current between these terminals. This output may appear at an output port 41 of evaluation circuit 40. Evaluation circuit 40 may be electrically connected to input terminal 11 and/or output terminal 12. As shown in Fig. 1, a first diode D1 links input terminal 11 with evaluation circuit 40, while a second diode D2 connects output terminal 12 to evaluation circuit 40. Evaluation circuit 40 is grounded to the same virtual ground as the connection point between switching modules 21 and 22 in semiconductor switching stage 20. Evaluation circuit 40 may also receive control signals for the switching elements within modules 21 and 22.

The output signal from evaluation circuit 40 may be sent to a trigger and control device 50. For example, output port 41 of evaluation circuit 40 could be electrically connected to an input port of trigger and control device 50. As illustrated in Fig. 1, capacitor C1 may be connected between output port 41 of evaluation circuit 40 and the virtual ground. Trigger and control device 50 generates appropriate control signals, which are applied to the control terminals of the semiconductor switches within semiconductor switching stage 20. Specifically, trigger and control device 50 may cause semiconductor switching stage 20 to interrupt the electrical connection between input terminal 11 and output terminal 12 upon detecting a predetermined condition. This condition could be, for instance, a current between input and output terminals 11 and 12 that exceeds a specified threshold, or an increase in the current gradient beyond a defined limit.

To assess the gradient of electric current between input terminal 11 and output terminal 12, components 31 and 32 may include inductive elements 312 and 322, such as coils or similar devices.

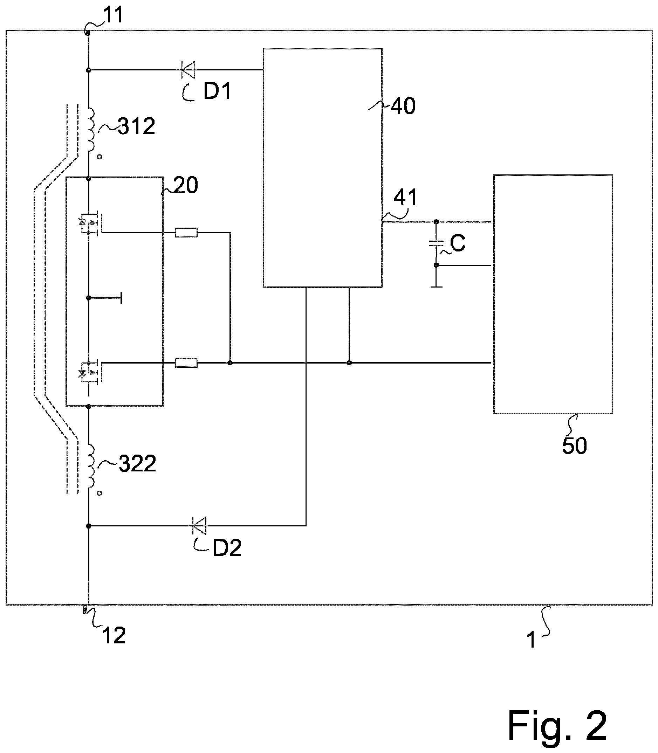

Fig. 2 shows a schematic diagram of power control apparatus 1 according to another embodiment. This apparatus is largely similar to the previously described power control apparatus in Fig. 1 but differs in that both electrical components 31 and 32 now contain coils 312 and 322, respectively, which are magnetically coupled. Specifically, coils 312 and 322 are positioned so that the magnetic field of the first coil 312, located between input terminal 11 and semiconductor switching stage 20, and the second coil 322, situated between semiconductor switching stage 20 and output terminal 12, constructively superimpose.

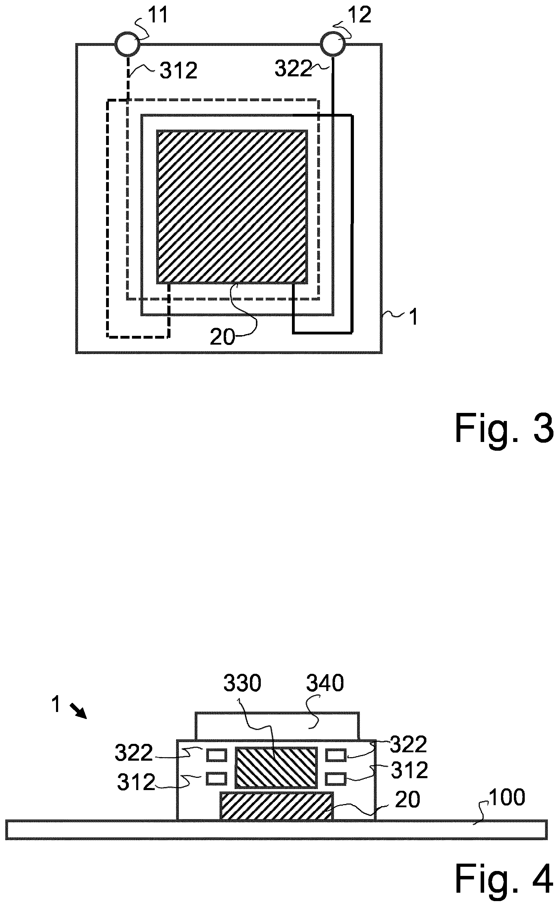

Fig. 3 shows a top view of power control apparatus 1 according to an embodiment. In this embodiment, power control apparatus 1 includes two magnetically coupled coils 312 and 322, as described in relation to Fig. 2. Coils 312 and 322 may be positioned one above the other. Alternatively, coils 312 and 322 could have a bifilar configuration.

Power control apparatus 1 also includes semiconductor switching stage 20, as previously described. Semiconductor switching stage 20 may be arranged, for instance, on a printed circuit board 100. Coils 312 and 322 might be positioned above semiconductor switching stage 20, effectively situating semiconductor switching stage 20 between coils 312 and 322 and the printed circuit board. Alternatively, coils 312 and/or 322 could encircle semiconductor switching stage 20, with the switching stage located within the loop formed by either or both coils.

Fig. 4 shows a cross-sectional view of power control apparatus 1 according to a further embodiment. Power control apparatus 1 in this embodiment also comprises two magnetically coupled coils 312 and 322, as already described above. In this embodiment, a magnetic core 330 may be arranged within coils 312 and 322. This magnetic core 330 may comprise a magnetically conductive material, such as ferrite or a similar material, to enhance the magnetic coupling between coils 312 and 322.

The magnetic core 330 is electrically isolated from the windings of both coil 312 and coil 322, as well as from semiconductor switching stage 20. This isolation may be achieved using appropriate insulating material, such as an insulating lacquer. Alternatively, insulating elements, such as an insulating film or foil, may be positioned between magnetic core 330 and the windings of coils 312 and 322 and/or semiconductor switching stage 20. In principle, magnetic core 330 may be entirely electrically isolated from all other components within the current path between input terminal 11 and output terminal 12.

Magnetic core 330 may also have thermally conductive properties. Specifically, magnetic core 330 may be thermally coupled with semiconductor switching stage 20 and/or coils 312 and 322. This allows magnetic core 330 to dissipate heat generated by semiconductor switching stage 20 and/or coils 312 and 322. Optionally, power control apparatus 1 may include a cooling element 340, which could provide additional cooling. Cooling element 340 may be thermally coupled to magnetic core 330, allowing it to transfer heat from semiconductor switching stage 20 and/or coils 312 and 322 to cooling element 340.

Cooling element 340 could be a passive device, such as a heatsink, potentially with cooling fins for heat dissipation. Alternatively, cooling element 340 could include an active cooler, such as a fan.

As shown in Fig. 4, some components of power control apparatus 1 may be embedded within a moulding material. For instance, coils 312 and 322 along with magnetic core 330 could be enclosed by moulding material. Optionally, the coils 312 and 322 and semiconductor switching stage 20 could also be embedded. The entire assembly, including coils 312 and 322, semiconductor switching stage 20, and additional components like evaluation circuit 40 and trigger and control device 50, may be encased in the moulding material.

The moulding material may have electrical insulating properties and may also be thermally conductive to aid in dissipating heat from individual components to the surrounding environment.

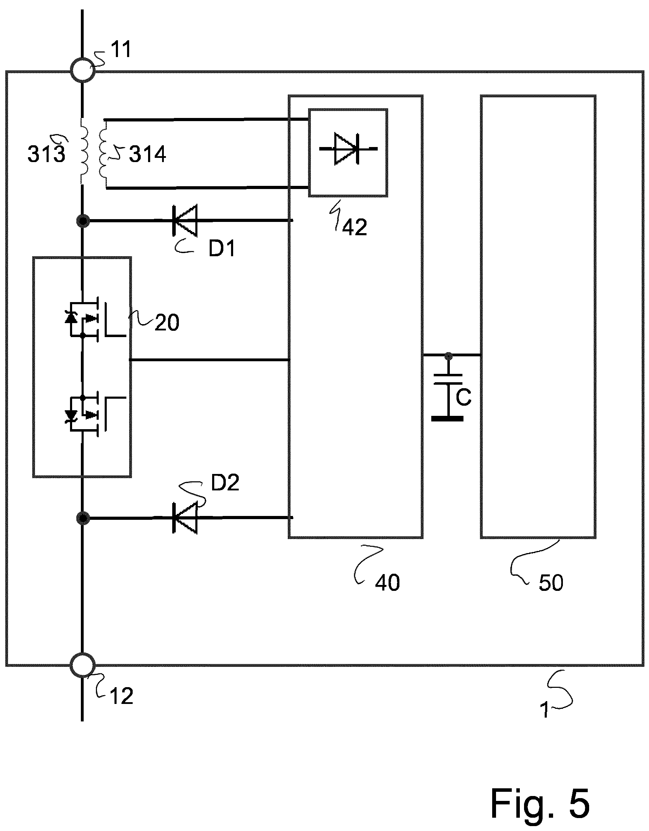

Fig. 5 shows power control apparatus 1 according to a further embodiment. In this version, power control apparatus 1 differs from the previously described apparatus (as shown in Fig. 1) by having a conductive element 313 positioned between input terminal 11 and semiconductor switching stage 20. Conductive element 313 may comprise a linear or nearly linear conductive line, such as a conductive path on a printed circuit board. For example, this conductive path may be a signal line made of copper or another conductive material. Alternatively, conductive element 313 could also be implemented as a conductive wire.

In addition, an induction element 314 may be located adjacent to conductive element 313. Induction element 314 may be formed by one or more loops-specifically, closed loops-of an electrically conductive material. For example, induction element 314 could be made using a conductive path on a printed circuit board, forming one or more loops near conductive element 313.

When current flows through conductive element 313 from input terminal 11 into semiconductor switching stage 20, it generates a surrounding magnetic field. This magnetic field can be detected by induction element 314, where it may induce a current. The resulting current or voltage may then be provided to evaluation circuit 40. Evaluation circuit 40 can analyse the output from induction element 314 to assess the current through conductive element 313, thereby determining the current between input terminal 11 and output terminal 12.

As depicted in Fig. 5, evaluation circuit 40 may include a rectifying circuit 42. Rectifying circuit 42 can rectify the output signal from induction element 314, thus producing a signal corresponding to the current between input terminal 11 and output terminal 12.

Although Fig. 5 shows conductive element 313 and induction element 314 between input terminal 11 and semiconductor switching stage 20, these elements could also be positioned between semiconductor switching stage 20 and output terminal 12. It may also be possible to place a conductive element 313 and an induction element 314 on both sides of semiconductor switching stage 20: one pair between input terminal 11 and the semiconductor switching stage 20, and another pair between the semiconductor switching stage 20 and output terminal 12.

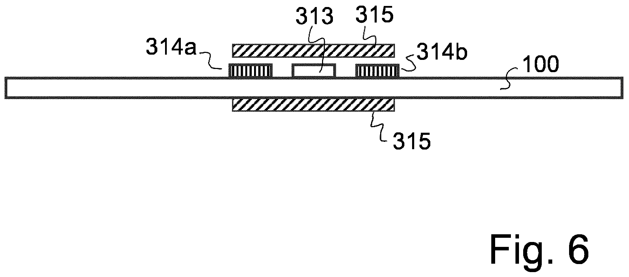

Fig. 6 provides a cross-sectional view of power control apparatus 1 in another embodiment. In this embodiment induction element 314 is divided into two sections, 314a and 314b. These sections are positioned on opposite sides of conductive element 313 and may be located on a printed circuit board 100. Both conductive element 313 and induction elements 314a and 314b could be implemented as conductive paths on printed circuit board 100.

One or more coupling elements 315 may also be added to the assembly with conductive element 313 and induction elements 314a and 314b. These coupling elements 315 may comprise magnetically conductive material, such as ferrite. Importantly, coupling elements 315 are electrically isolated from conductive element 313 and induction elements 314a and 314b, possibly through an insulating coating or foil. A coupling element 315 could be situated above or below the arrangement of conductive element 313 and induction elements 314a and 314b, potentially on the opposite side of printed circuit board 100.

In addition to the configurations of conductive element 313 and induction element 314 described above, other setups, such as planar transformers or flat-type transformers, may be used to transfer current in the path between input terminal 11 and output terminal 12 to a separate galvanically isolated section. This setup could produce an output signal that corresponds to the current between input terminal 11 and output terminal 12.

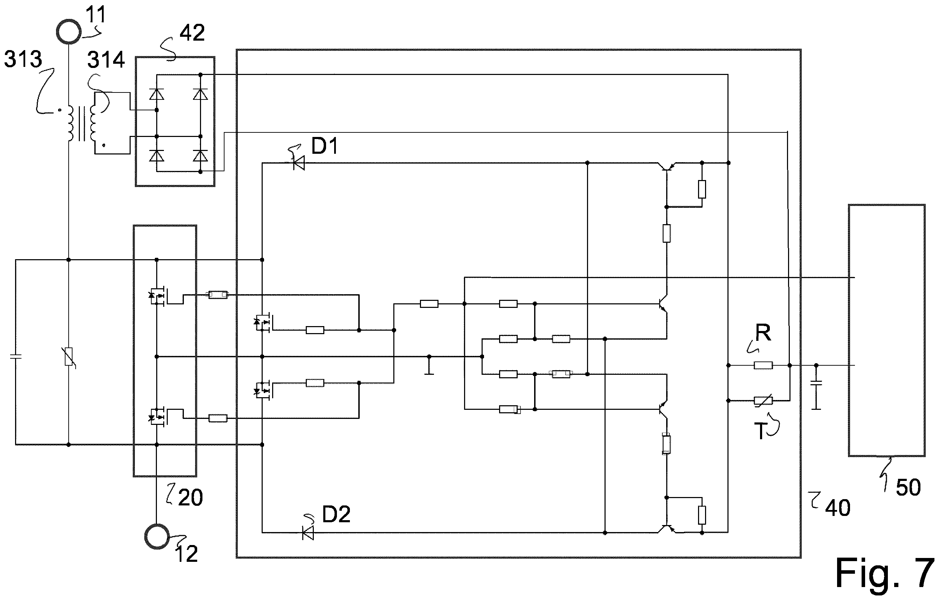

Fig. 7 shows a schematic circuit diagram of power control apparatus 1 according to an embodiment. In this embodiment, power control apparatus 1 utilises the previously described configuration of conductive element 313 and induction element 314. The output signal provided by induction element 314 may be rectified by rectifier circuit 42, and the resulting output is fed to evaluation circuit 40. This signal may then be used to assess the gradient of current flowing between input terminal 11 and output terminal 12.

Additionally, evaluation circuit 40 may be connected via diode D1 to the connection point between conductive element 313 and semiconductor switching stage 20. It may also connect via diode D2 to the point between semiconductor switching stage 20 and output terminal 12. These signals can be utilised to evaluate the amplitude of the current flowing between input terminal 11 and output terminal 12.

The output signal from evaluation circuit 40 may be provided at an output terminal 41, which may also connect to capacitor C1. The opposite terminal of capacitor C1 may be connected to virtual ground. The output signal at output terminal 41 may then be received by trigger and control circuit 50.

Some components of power control apparatus 1 may exhibit temperature-dependent properties. For instance, the resistance of the semiconductor switches within semiconductor switching stage 20, when in a closed (conductive) state, may vary depending on the temperature of each respective semiconductor and, consequently, on the temperature of semiconductor switching stage 20. This dependency might be linear or follow another specific function. Additionally, other elements within power control apparatus 1 may also exhibit temperature-related dependencies.

To account for this temperature dependency, power control apparatus 1 may apply a suitable temperature compensation mechanism. For example, a temperature-dependent resistor T may be used, positioned near or close to semiconductor switching stage 20. As illustrated in Fig. 7, temperature-dependent resistor T may be arranged in parallel with an additional resistor R. Both temperature-dependent resistor T and additional resistor R could be placed in parallel between the two output terminals of rectifier circuits 42.

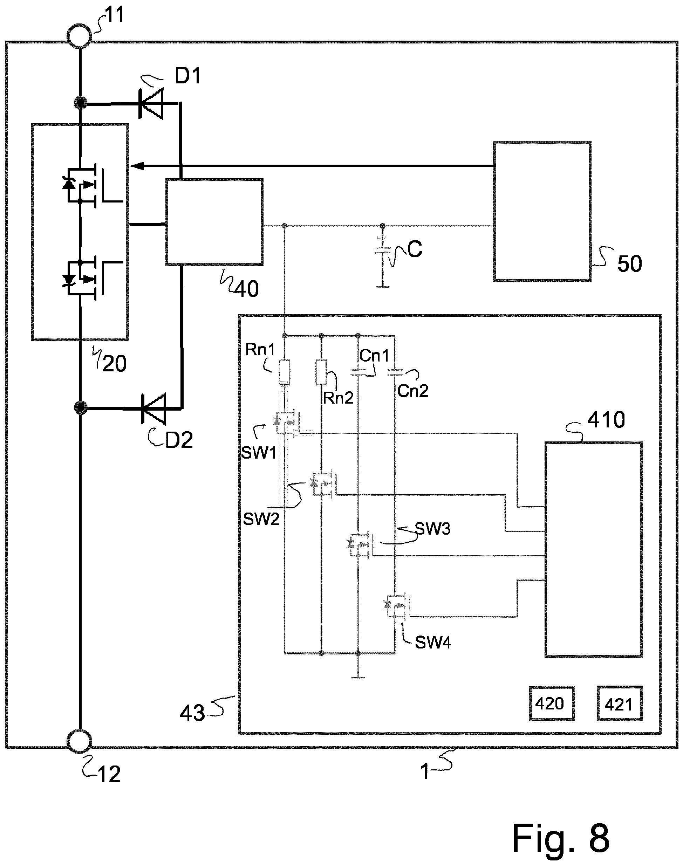

Fig. 8 shows a schematic diagram of power control apparatus 1 according to a further embodiment. In this version, power control apparatus 1 includes a thermal compensation unit 43, located at output port 41 of evaluation circuit 40. In a simple configuration, thermal compensation unit 43 may consist of at least one temperature-dependent resistor T, as described previously.

Alternatively, thermal compensation unit 43 may include a compensation network, as depicted in Fig. 8. This compensation network could contain multiple elements, such as resistors or capacitors. Although the example in Fig. 8 illustrates a network with two resistors Rn1 and Rn2 and two capacitors Cn1 and Cn2, any other number or combination of elements could be possible. Furthermore, each path of the compensation network may contain a combination of multiple electronic components.

Each path in the compensation network may be individually activated or deactivated. For this purpose, each path may include a switch SW1-SW4. The switches SW1-SW4 may be semiconductor switches, such as MOSFETs.

A path can be activated by closing the respective switch SW1-SW4, and deactivated by opening the switch. Any suitable combination of paths may be applied, and it could be possible to activate multiple paths in parallel.

Control unit 410 could manage the operation of each switch SW1-SW4, providing individual control signals for each switch. Control unit 410 may consider the temperature of power control apparatus 1, particularly the temperature of semiconductor switching stage 20 and/or other components. For example, one or more temperature sensors could be positioned appropriately - such as close to semiconductor switching stage 20 - to provide temperature readings. The sensor signal could be sent to control unit 410 via an appropriate interface 420.

Alternatively, it may be possible to estimate the temperature of power control apparatus 1, specifically semiconductor switching stage 20, using a temperature model. For instance, based on the current flowing between input terminal 11 and output terminal 12, power control apparatus 1 could calculate an estimated temperature of semiconductor switching stage 20.

Additionally, control unit 410 may receive other relevant data or information, potentially through interface 420, which could also receive signals from a temperature sensor. Alternatively, a separate interface 420 could be used to collect additional data. This data could specify the degree of temperature dependency required for the compensation network, enabling an adjustment of the temperature-dependent function accordingly. This information could be provided digitally, possibly via a communication protocol, or manually configured through an input device 421. Such an input device could include switches, jumpers, or similar controls, allowing users to easily configure these to achieve the desired setup.

In summary, the present invention relates to a power control apparatus for controlling an electrical current between an input terminal and an output terminal. The current in the path between these two terminals can be monitored by an arrangement comprising a nearly linear conductive element positioned in the current path, and an inductive element that receives the magnetic field generated by the conductive element. The arrangement of the conductive element and the inductive element may form a configuration similar to a planar transformer.

## Claims

1. A power control apparatus (1) for controlling electrical power supplied to a connected load (3), said power control apparatus (1) comprising:
an input terminal (11) configured to be connected to an electrical power source (2);
an output terminal (12) configured to be connected to the load (2) ;
a semiconductor switching stage (20) through which the connected load (2) receives a load current, wherein the semiconductor switching stage (2) comprises at least two power switches arranged in series between the input terminal (11) and the output terminal (12), and wherein the two power switches have opposite orientations,
a conductive element (313) in a current path between the input terminal (11) and the output terminal (12),
an induction element (314) adapted to receive a magnetic field generated by the conductive element (313) and to provide an output signal corresponding to the magnetic field; and
an evaluation circuit (40) adapted to evaluate a current between the input terminal (11) and the output terminal (12) based on a voltage provided by the induction element (314) .

2. The power control apparatus (1) according to claim 1,
wherein the induction element (314) is formed as an electrically conductive structure on a printed circuit board (100).

3. The power control apparatus according to claim 1 or 2,
wherein the conductive element (313) is formed as an electrically conductive structure on the printed circuit board (100).

4. The power control apparatus (1) according to any of claims 1 to 3, wherein the conductive element (313) is formed as a linear electrically conductive structure.

5. The power control apparatus (1) according to any of claims 1 to 4, wherein the induction element (314) comprises only a single inductive structure alongside the conductive element (313).

6. The power control apparatus (1) according to any of claims 1 to 4, wherein the induction element (314) comprises two sections (314 a, 314b) on the printed circuit board (100) at opposite sides of the conductive element (313).

7. The power control apparatus (1) according to any of claims 1 to 6, comprising a coupling element (315) adapted to magnetically couple the conductive element (313) and the inductive element (314).

8. The power control apparatus (1) according to claim 7,
wherein the coupling element (315) comprises a magnetically conductive material, and
wherein the coupling element (315) is located above and/or below a printed circuit board (100) with the conductive element (313) and the inductive element (314).

9. The power control apparatus (1) according to any of claims 1 to 8, wherein the conductive element (313) is arranged between the input terminal (11) and the semiconductor switching stage (20) and/or between the semiconductor stage (20) and the output terminal (12).

10. The power control apparatus (1) according to any of claims 1 to 9, wherein the current evaluation circuit (40) comprises a rectifier circuit (42) configured to rectify an output voltage of the induction element (314).
